(19) Europäisches Patentamt
European Patent Office
Office européen des brevets

(11) **EP 1 001 270 B1**

(12) **EUROPÄISCHE PATENTSCHRIFT**

(45) Veröffentlichungstag und Bekanntmachung des Hinweises auf die Patenterteilung:
**01.09.2004 Patentblatt 2004/36**

(51) Int Cl.⁷: **G01R 31/02**, G01R 31/11, G01R 27/18

(21) Anmeldenummer: **99120727.5**

(22) Anmeldetag: **20.10.1999**

(54) **Verfahren zur Prüfung einer Erdverbindung**

Method for testing a ground connection

Procédé pour tester une connexion à la terre

(84) Benannte Vertragsstaaten:
**AT BE CH CY DE DK ES FI FR GB GR IE IT LI LU MC NL PT SE**

(30) Priorität: **14.11.1998 DE 19852591**

(43) Veröffentlichungstag der Anmeldung:
**17.05.2000 Patentblatt 2000/20**

(73) Patentinhaber: **DaimlerChrysler AG**
**70567 Stuttgart (DE)**

(72) Erfinder:
• **Heck, Thomas**
**70839 Gerlingen (DE)**

• **Schüle, Carsten**
**71686 Remseck (DE)**

(56) Entgegenhaltungen:
EP-A- 0 045 113   DE-A- 19 650 974
US-A- 4 491 782   US-A- 4 638 244

• **HE JINLIANG ET AL: "Impulse characteristics of grounding systems of transmission-line towers in the regions with high soil resistivity" POWER SYSTEM TECHNOLOGY, 1998. PROCEEDINGS. POWERCON '98. 1998 INTERNATIONAL CONFERENCE ON BEIJING, CHINA 18-21 AUG. 1998, NEW YORK, NY, USA,IEEE, US, 18. August 1998 (1998-08-18), Seiten 156-162, XP010312589 ISBN: 0-7803-4754-4**

**Beschreibung**

Die Erfindung betrifft ein Verfahren zur Prüfung der Erdverbindung einer an einen Erder angeschlossenen elektrischen Vorrichtung.

Erdverbindungen enthalten Erdungsanlagen, welche als Schutzerdung, Betriebserdung und Blitzschutzerdung eingesetzt werden. Bei elektrischen Vorrichtungen, Anlagen und elektrisch leitfähigen Teilen werden Erdungsanlagen als Maßnahme zum Schutz von Personen gegen zu hohe Berührungs- oder Schrittspannungen eingesetzt. Im Fehlerfall (z.B. Erdschluß) muß die Erdungsanlage den Strom "tragen" können, der zur Auslösung eines der elektrischen Anlage vorgeschalteten Schutzorgans (z.B. Schutzschalter) fließt.

Eine Erdungsanlage enthält üblicherweise mindestens einen Erder, der in das Erdreich eingebettet ist und mit dem Erdreich in leitender Verbindung steht. Der Erder ist z.B. als Band-, Platten- oder Staberder ausgebildet. Eine sogenannte Erdleitung verbindet die zu erdende Vorrichtung mit dem Erder.

Insbesondere durch Kurzschlußströme und Korrosion können Erdungsanlagen beschädigt oder zerstört werden. Deshalb ist eine regelmäßige Überprüfung der Erdungsimpedanz und der Stromtragfähigkeit der Erdungsanlage von großer Bedeutung. In DE wird z.B. gemäß VDE 0105/Teil 1, Abs.5.3 gefordert, daß die Stromtragfähigkeit von Erdungsanlagen durch Prüfung des Gebäudeerders zu gewährleisten ist. Dabei ist die Überprüfung in vielen Fällen regelmäßig - z.B. im Abstand von 5 Jahren - zu wiederholen. Da derzeit kein geeignetes Prüfverfahren zur Bestimmung der Stromtragfähigkeit von Erdungsanlagen existiert, ist gemäß DIN 57141/VDE 0141 ein Aufgraben der Erdungsanlage zur optischen Sichtkontrolle notwendig. Dies ist jedoch regelmäßig mit einem hohen Kostenaufwand verbunden. Außerdem können beim Aufgraben des Erdreichs elektrische oder andere Leitungen beschädigt werden, wenn sie in der Nähe der Erdungsanlage verlegt sind.

Der Erfindung liegt die Aufgabe zugrunde, ein Verfahren zu schaffen, das auf einfache Weise eine zuverlässige Prüfung einer Erdverbindung ermöglicht.

Diese Aufgabe wird durch die Merkmalskombination des Anspruches 1 gelöst.

Erfindungsgemäß wird mindestens ein elektrisches Signal oder eine Folge mehrerer Signale nach dem Prinzip des Echolotes (= Impulsreflexionsverfahren) in den Erder oder die Erdungsanlage eingespeist. Das eingespeiste Signal wird insbesondere an Fehlerstellen wie Korrosionsstellen, Beschädigungen etc. des Erders reflektiert. Das reflektierte Signal bzw. die reflektierte Signalfolge wird mit geeigneten Mitteln als ein erstes Meßergebnis gemessen. Vorzugsweise wird das Meßergebnis in einen Speicher abgelegt oder auf andere Art und Weise reproduzierbar abgelegt. Danach wird der Erder mit einer definierten elektrischen Prüfenergie (z.B. Nennspannung, Nennstrom) belastet. Hierbei wird die Prüfenergie vorzugsweise derart vorbestimmt, daß sie mindestens oder ein Mehrfaches der in einem Störfall über den Erder abfließenden elektrischen Energie entspricht. Um die Auswirkungen dieses simulierten Störfalles auf den mechanischen Zustand der Erdverbindung zu prüfen, wird nach beendeter Belastung erneut dasselbe mindestens eine elektrische Signal nach dem Prinzip des Echolotes in den Erder eingespeist und nach der Reflexion als ein zweites Meßergebnis gemessen sowie ggfs. in einem Speicher abgelegt. Danach werden das erste und das zweite Meßergebnis miteinander verglichen, um etwaige Abweichungen voneinander festzustellen.

Derartige Abweichungen zeigen dem Prüfpersonal zuverlässig an, daß die Erdungsanlage durch den simulierten Störfall beschädigt oder zerstört worden ist, als Schutzmaßnahme für einen echten Störfall also untauglich ist und deshalb ausgetauscht werden muß. Dabei kann davon ausgegangen werden, daß relevante Abweichungen, d.h. sicherheitstechnisch relevante Beschädigungen der Erdverbindung zwischen den beiden Meßergebnissen vor allem dann auftreten, wenn die Erdverbindung bereits vor der Belastung mittels der Prüfenergie Fehlerstellen aufweist, welche durch die Prüfenergie nur noch verstärkt und dadurch eindeutig aufgezeigt werden. Das Verfahren bietet deshalb ein eindeutiges Ergebnis bei der Sicherheitsüberprüfung der Erdverbindung. Außerdem kann der Aufbau und die Qualität einer Erdungsanlage vor der Belastung bereits durch die Form des ersten Meßergebnisses grob abgeschätzt werden.

Zeigen die beiden Meßergebnisse hingegen keine relevanten Abweichungen voneinander, so ist der Zustand der Erdverbindung durch die Prüfenergie nicht verändert worden. Die Erdverbindung muß deshalb vor der Belastung in einem guten Zustand gewesen sein, da es anderenfalls zu relevanten Abweichungen zwischen dem ersten und dem zweiten Meßergebnis gekommen wäre.

Die Meßergebnisse können im Zuge der Auswertung dokumentiert, abgespeichert und archiviert werden, um einen Vergleich bei späteren Wiederholungsprüfungen zu haben. Hierdurch können Zustandsveränderungen der Erdverbindung besonders effizient überwacht werden.

Mit dem Prüfverfahren wird auf aufwendige Grabungsarbeiten sowie eine anschließende optische und deshalb ungenaue Prüfung der Erdungsanlage zugunsten eines besonders zuverlässigen elektrischen Prüfverfahrens verzichtet. Dabei ist das Prüfverfahren unter Zuhilfenahme bekannter Meßmethoden (Impulsreflexions-Prinzip) kostengünstig vorzugsweise mit herkömmlichen Geräten durchführbar. Die Durchführung des Prüfverfahrens ist deshalb besonders bedienungsfreundlich. Das Prüfverfahren kann bei Gleichstrom- und bei Wechselstrom-Netzen unabhängig von der Stromform angewandt werden.

Vorzugsweise werden Signale mit genau festgelegter Zeitfolge und Form mittels eines Impulsgenerators eingespeist. Vorteilhaft handelt es sich bei dem elektrischen Signal um einen kurzen Impuls mit steiler Flanke (= Nadelimpuls), so daß Fehlerstellen durch die Impulsreflexion an den Teilimpedanzen der Erdungsanlage (indüktiver, kapazitiver, ohmscher Anteil) anhand des reflektierten ersten Meßergebnisses und beim Vergleich der beiden Meßergebnisse besonders gut erkennbar sind.

Es sei erwähnt, daß der einen Bestandteil der zu überprüfenden Erdverbindung bildende Erder der elektrischen Vorrichtung während des Verfahrens an keinen Potentialausgleicher (z.B. Potentialausgleichschiene) elektrisch angeschlossen sein darf, welcher gleichzeitig - z.B. über Potentialausgleichleitungen - mit Erdern anderer elektrischer Vorrichtungen, Anlagenteilen, Stahlträgern etc. oder mit dem Erder der während des Prüfverfahrens benutzten Energiequelle elektrisch verbunden ist. Deshalb wird der Erder vorzugsweise bereits vor Beginn des Prüfverfahrens, d.h. vor dem Einspeisen eines Signals in den Erder und seiner Messung als erstes Meßergebnis, von dem mit ihm verbundenen Potentialausgleicher elektrisch getrennt (Anspruch 2). Ist der Zustand der Erdverbindung gemäß Prüfverfahren in Ordnung, kann der Erder wieder an den Potentialausgleicher angeschlossen werden.

Ein Beispiel für eine elektrische Vorrichtung, deren zugeordneter Erder (= Vorrichtungs-Erder)zur Durchführung des Prüfverfahrens von der Vorrichtung getrennt werden muß, ist ein elektrisches Gerät wie etwa ein Motor. Dieses elektrische Gerät wird im Betriebszustand von einer ihm zugeordneten elektrischen Energiequelle versorgt. Dabei sind ein der Energiequelle zugeordneter Erder (= Quellen-Erder) und der Vorrichtungs-Erder durch eine Potentialausgleichleitung und Potentialausgleichschienen miteinander elektrisch verbunden. Zur Überprüfung der Erdverbindung ist der Vorrichtungs-Erder deshalb zunächst von dem Erder derjenigen Energiequelle zu trennen, welche zur Durchführung des Prüfverfahrens der Vorrichtung zugeordnet ist.

Ein weiteres Beispiel für eine elektrische Vorrichtung ist eine Blitzschutzanlage. Deren Erder kann bereits im Betriebszustand von Potentialausgleichern (innere Erdung) der Energiequellen, elektrischen Anlagen und anderen elektrischen Vorrichtungen getrennt sein. Vor dem Anschluß einer Phase der verwendeten Ewergiequelle an die Blitzschutzanlage bzw. deren Erder muß das Prüfpersonal deshalb nur bei einer leitenden Verbindung zwischen Anlagen-/Gebäudeerdern und Blitzschutzerdern eine Trennung vornehmen.

Neben einer Ausgestaltung als elektrisches Gerät oder Verbraucher kann die elektrische Vorrichtung auch selbst eine Energiequelle, z.B. ein Hausanschlußkasten sein. Dieser Vorrichtung ist wiederum eine Energiequelle zugeordnet, z.B. ein Ortsnetztrafo. Die Vorrichtung kann auch als Transformator, Netzstation od. dgl. ausgebildet sein. Die Energiequelle ist in bevorzugten Ausführungsformen als (Stoß-)Generator, Batterie, Transformator od. dgl. ausgebildet.

Gemäß Anspruch 3 ist die Prüfenergie durch einen Prüfstrom realisiert. Somit kann auf einfache Weise die Stromtragfähigkeit der Erdungsanlage geprüft werden. Vorzugsweise ist der Prüfstrom ein mehrfacher Wert des Nennstromes oder größer als der erwartete Kurzschlußstrom, so daß eine möglichst große Stromtragfähigkeit nachgewiesen und eine Aussage über den theoretisch möglichen Wert des Kurzschlußstromes getroffen werden kann.

Die Maßnahmen nach Anspruch 4 unterstützen eine wirklichkeitsgetreue Simulation eines Störfalles während des Prüfverfahrens. Die hierdurch erzielten Meßergebnisse unterstützen eine exakte Einstufung des tatsächlichen Zustandes der Erdverbindung.

Die Ansprüche 5 bis 7 schlagen Maßnahmen vor, um die Erdungsimpedanz der Erdverbindung unaufwendig mittels Impedanzmessungen zu bestimmen. Dabei wird vorteilhaft der Realanteil der Erdungsimpedanz als Erdungswiderstand ermittelt. Somit gibt die Erdungsimpedanz eine detaillierte Auskunft über die Beschaffenheit der Erdungsanlage: Beispielsweise weist ein im Vegleich zu seinem Realanteil großer Imaginäranteil der Erdungsimpedanz auf eine starke Vermaschung der Erdungsanlage hin, d.h. es existiert ein vermaschtes Netz von Erdern mit Erderkabeln, welche von Potentialausgleicher zu Potentialausgleicher durchgeschleift sind. Ist der Imaginäranteil im Vergleich zu dem zugeordneten Realanteil hingegen sehr gering, handelt es sich um einen Gebäudeerder z.B. in Form eines Staberders. Gleichzeitig kann überprüft werden, ob die Erdungsimpedanz bzw. der Erdungswiderstand einen für die Betriebssicherheit der Erdungsanlage höchstzulässigen Wert nicht überschreitet. Die Messung der Netzimpedanz zur Ermittlung des Erdungswiderstandes hat den zusätzlichen Vorteil, daß weitere Aussagen über das Netz selbst (z.B. Vermaschungsart, Vermaschungstiefe) gemacht werden können

Die Impedanzmessungen werden vorzugsweise mit herkömmlichen Impedanzmeßverfahren durchgeführt. Für die Messungen kann deshalb auf herkömmliche Impedanzmeßgeräte zurückgegriffen werden. Speziell an das Prüfverfahren angepaßte, neuentwickelte Meßvorrichtungen werden kostensparend vermieden.

Gemäß Anspruch 8 erfolgt die Impedanzmessung zwischen Phase und Erde während der Belastung der Erder bzw. der Erdungsanlage mit der Prüfenergie, wodurch die Prüfenergie in einer weiteren Funktion als Meßenergie wirksam ist. Der Zeit- und Kostenaufwand für die Durchführung des Verfahrens sind hierdurch weiter reduziert.

Der Erfindungsgegenstand wird anhand der in den Figuren dargestellten Ausführungsbeispiele näher erläutert. Es zeigen:

Fig. 1 ein Flußdiagramm für den Ablauf einer Ausführungsform des erfindungsgemäßen Verfahrens,

Fig. 2 eine schematische Darstellung einer Messung einer Gesamtimpedanz anhand eines dreiphasigen Netzes mit einem Motor als elektrische Vorrichtung,

Fig. 3 ein Ersatzschaltbild der Gesamtimpedanz gemäß Fig.2,

Fig. 4 eine schematische Darstellung einer Messung einer Netzimpedanz anhand des dreiphasigen Netzes gemäß Fig.2,

Fig. 5 ein Ersatzschaltbild der Netzimpedanz gemäß Fig.4 und

Fig. 6 eine schematische Darstellung einer Messung einer Gesamtimpedanz anhand eines dreiphasigen Netzes mit einer Blitzschutzanlage als elektrische Vorrichtung.

Vor dem Beginn der eigentlichen Prüfung der Erdverbindung wird festgestellt, ob der im Betriebszustand an die elektrische Vorrichtung 10 angeschlossene Vorrichtungs-Erder 11 an eine mit dem Quellen-Erder 12 der Energiequelle 13 verbundene Potentialausgleichschiene 14 elektrisch angeschlossen ist. Ist dies der Fall, wird der Vorrichtungs-Erder 11 von der Potentialausgleichschiene 14' elektrisch getrennt. Die Potentialausgleichschienen 14 und 14' sind durch Potentialausgleichleitungen od. dgl. miteinander elektrisch verbunden.

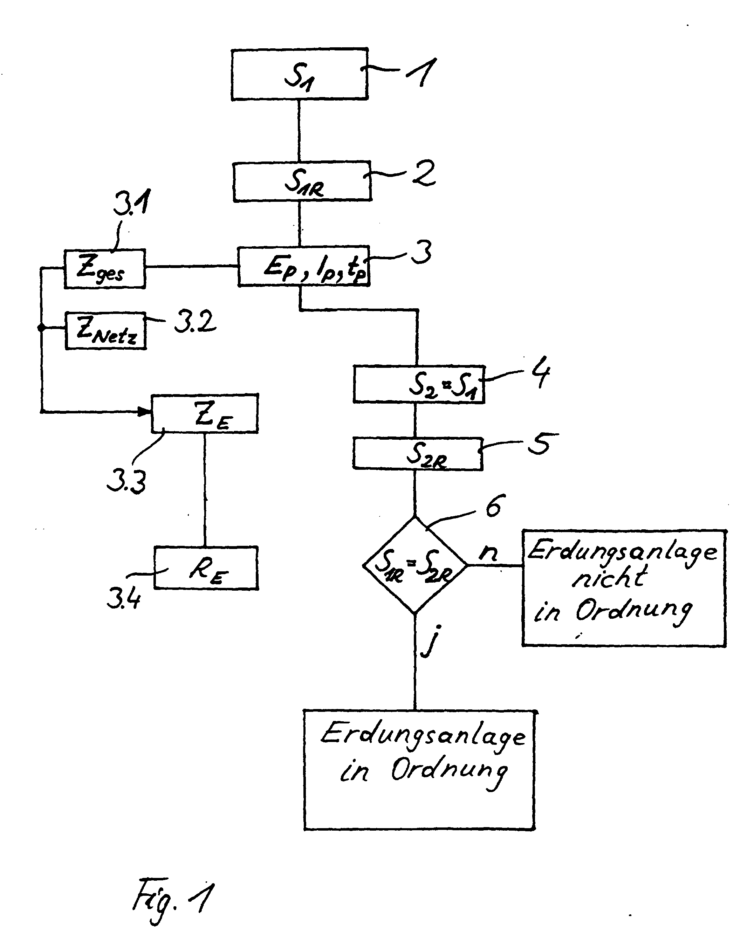

Zu Beginn des eigentlichen Prüfverfahrens wird in einem Schritt 1 gemäß dem Impulsreflexionsverfahren ein impulsartiges elektrisches Signal $S_1$ in den Vorrichtungs-Erder 11 eingespeist (Fig.1). Im Schritt 2 wird das reflektierte Signal $S_{1R}$ gemessen und festgehalten, insbesondere abgespeichert. Danach wird die Erdverbindung in einem Schritt 3 mit einer elektrischen Prüfenergie $E_p$ belastet. Als Prüfenergie $E_p$ ist insbesondere ein vorbestimmter Prüfstrom $I_p$ geeignet, der während einer vorbestimmten Prüfzeitdauer $t_p$ über den Vorrichtungs-Erder 11 abfließt und einen Kurzschluß simuliert. Dabei entspricht die Prufzeitdauer $t_p$ vorzugsweise der Ansprechzeit eines Auslöseorgans 15 (z.B. Überstrom-Schutzschalter, Sicherung), welches zwischen geerdete elektrische Vorrichtung 10 und selbige Vorrichtung 10 versorgende Energiequelle 13 geschaltet ist und im Störfall die Vorrichtung 10 von der Energiequelle 13 trennt.

Nachdem die Belastung der Erdverbindung beendet ist, wird gemäß dem Impulsreflexionsverfahren erneut ein Signal $S_2$ - wobei gilt: $S_2 = S_1$ - in den Vorrichtungs-Erder 11 eingespeist. Das reflektierte Signal $S_{2R}$ wird im Schritt 5 als ein zweites Meßergebnis gemessen und ggfs. mittels einer entsprechenden Verarbeitungseinheit festgehalten oder abgespeichert. In einem Schritt 6 wird das erste Meßergebnis mit dem zweiten Meßergebnis verglichen. Für diesen Vergleich ist vorzugsweise ebenfalls eine geeignete Verarbeitungseinheit in den Meßmitteln vorgesehen. Stimmen die beiden vorgenannten Meßergebnisse - abgesehen von ggfs. in einem bestimmten Umfang zugelassenen Abweichungen - miteinander überein, ist die Erdverbindung in einem ordnungsgemäßen Betriebszustand. Der Vorrichtungs-Erder 11 kann dann wieder an die Potentialausgleichschiene 14' angeschlossen werden. Weichen die beiden Meßergebnisse voneinander ab, ist die Erdverbindung nicht in Ordnung. Die Erdungsanlage bzw. deren defekten Bestandteile müssen dann ausgetauscht werden. Eine von der Verarbeitungseinheit in Abhängigkeit des Vergleichsergebnisses angesteuerte optische Anzeige, akustische Anzeige od. dgl. kann dem Prüfpersonal den jeweiligen Zustand der Erdverbindung signalisieren.

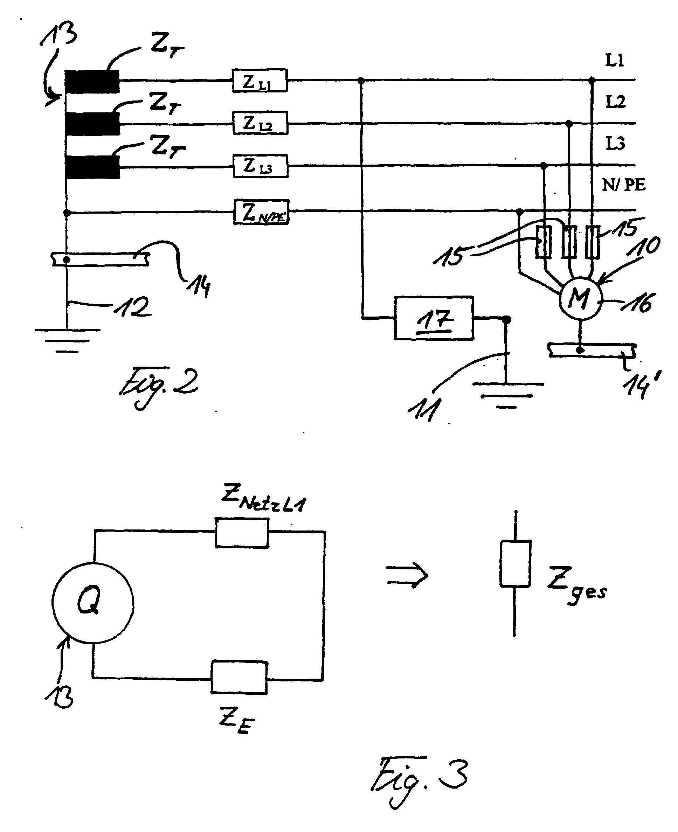

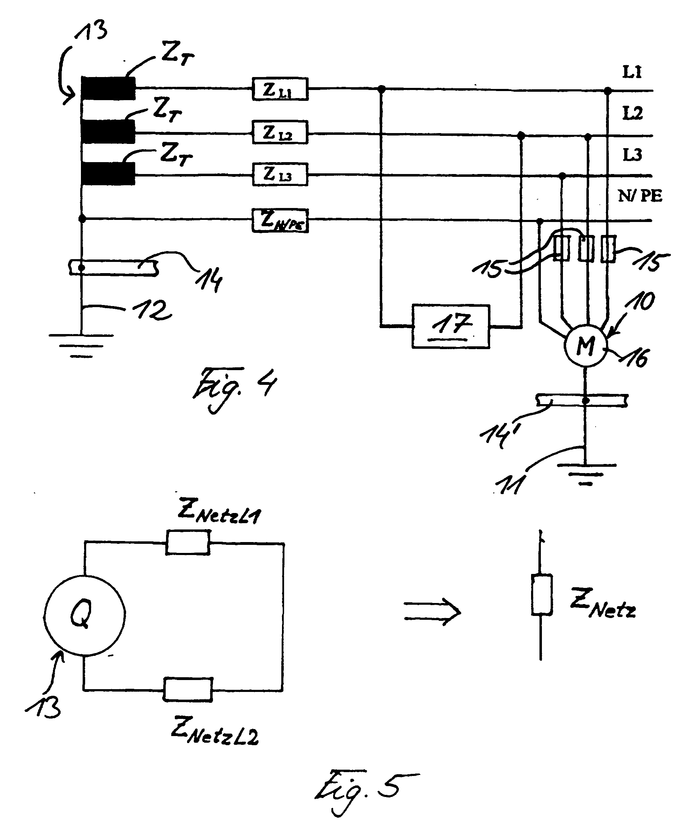

Wie in Fig.1 weiterhin dargestellt ist, wird der Prüfstrom Ip als Meßstrom zur Ermittlung einer Gesamtimpedanz $Z_{ges}$ herangezogen (Schritt 3.1). Die Messung sei beispielhaft anhand eines Transformators als dreiphasige Energiequelle 13 und einem von der Energiequelle 13 versorgten Motor 16 als elektrische Vorrichtung 10 dargestellt: Zur Messung der Gesamtimpedanz $Z_{ges}$ wird ein Impedanzmeßgerät 17 zwischen die Phase L1 - möglich ist auch jede andere Phase (hier: Phasen L2, L3) - und den von der Potentialausgleichschiene 14' elektrisch getrennten Vorrichtungs-Erder 11 geschaltet. Bei einer einphasigen Energiequelle wird das Impedanzmeßgerät 17 selbstverständlich zwischen die einzige Phase L1 und den getrennten Vorrichtungs-Erder 11 geschaltet. Die gemäß Fig.2 gemessene Gesamtimpedanz $Z_{ges}$ setzt sich im wesentlichen als Summe aus Erdungsimpedanz $Z_E$ und Phasen-Netzimpedanz $Z_{NetzL1}$ zusammen (Fig.3)

$$Z_{ges} \approx Z_{NetzL1} + Z_E \qquad (1)$$

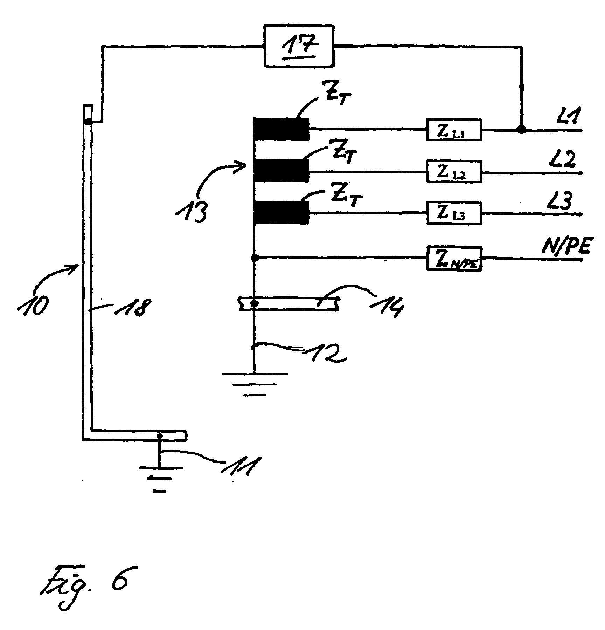

wobei die Erdungsimpedanz $Z_E$ die Impedanz der Erdschleife vom zu prüfenden Punkt bis zur Energiequelle 13 repräsentiert und die Phasen-Netzimpedanz $Z_{NetzL1}$ im wesentlichen eine Reihenschaltung aus Phasenimpedanz $Z_{L1}$ und Transformatorimpedanz $Z_T$ beinhaltet.
Für die Ermittlung der Erdungsimpedanz $Z_E$ muß außerdem die Netzimpedanz $Z_{Netz}$ gemessen werden (Schritt 3.2). Diese Messung kann zeitlich unabhängig vom Ablauf der Verfahrensschritte 1 bis 6, also z.B. auch zeitlich vor dem Schritt 1 erfolgen. Für die Messung kann ein für die zu messende Erdungsanlage relevanter Meßstrom verwendet werden. Die Messung sei beispielhaft an dem dreiphasigen Netz gemäß Fig.2 und Fig.4 dargestellt: Zur Messung der Netzimpedanz $Z_{Netz}$ wird das Impedanzmeßgerät 17 zwischen die Phasen L1 und L2 - möglich sind auch zwei andere Phasen L1,L2,L3 - geschaltet. Das Impedanzmeßgerät 17 kann auch zwischen eine Phase L1,L2,L3 und den Neutral- bzw. Schutzleiter N/PE geschaltet werden, da die Transformatorimpedanz $Z_T$ gegenüber der Phasenimpedanz $Z_{L1}, Z_{L2}, Z_{L3}$ vernachlässigbar klein ist, so daß gilt:

$$Z_{NetzL1} \approx Z_{NetzL2} \approx Z_{NetzL3} \approx Z_{N/PE} \qquad (2)$$

Das Prüfverfahren kann deshalb auch problemlos bei einphasigen Energiequellen 13 angewandt werden.

Die Netzimpedanz $Z_{Netz}$ gemäß Fig.4 setzt sich im wesentlichen als Summe aus Phasen-Netzimpedanz $Z_{NetzL1}$ der Phase L1 und Phasen-Netzimpedanz $Z_{NetzL2}$ der Phase L2 zusammen (Fig.5),

$$Z_{Netz} = Z_{NetzL1} + Z_{NetzL2} \qquad (3)$$

wobei die Phasen-Netzimpedanz $Z_{NetzL2}$ analog zur Phasen Netzimpedanz $Z_{NetzL1}$ im wesentlichen eine Reihenschaltung aus Phasenimpedanz $Z_{L2}$ und Transformatorimpedanz $Z_T$ beinhaltet. Aufgrund von Gleichung (2) und durch Verknüpfung der Gleichungen (1) und (3) folgt

$$Z_E \approx Z_{ges} - \tfrac{1}{2} Z_{Netz} \qquad (4)$$

Somit läßt sich die Erdungsimpedanz $Z_E$ durch Messen von Netzimpedanz $Z_{Netz}$ und Netz-Erdungsimpedanz $Z_{ges}$ ermitteln (Fig.1, Schritt 3.3). Da die Erdungsimpedanz $Z_E$ sowohl einen Realanteil $R_E$ als auch einen Imaginäranteil $X_E$ enthalten kann, gilt:

$$Z_E = R_E + X_E \qquad (4)$$

Mittels einer Auswerteeinheit od. dgl. werden aus dem Phasenwinkel der Erdungsimpedanz $Z_E$ die exakten Werte des Realanteiles $R_E$ (= Erdungswiderstand) und des Imaginäranteiles $X_E$ ermittelt (Fig.1, Schritt 3.4). Somit ist eine verfahrenstechnisch einfach realisierbare zusätzliche Überprüfung der Erdungsanlage möglich. Aus dem Phasenwinkel bzw. aus dem Verhältnis von Erdungsimpedanz $Z_E$ und Erdungswiderstand $R_E$ lassen sich Rückschlüsse auf den Charakter der Erdungsanlage ziehen. So ist die Erdungsanlage nahezu rein ohmisch, wenn der Phasenwinkel gegen 0° geht. Aus einem im Vergleich zum induktiven Anteil ausgeprägten ohmschen (= realen) Anteil der Erdungsimpedanz $Z_E$ kann man schließen, daß die Rückführung der Erdverbindung zur speisenden Energiequelle 13 nicht innerhalb desselben Gebäudefundaments, sondern von einem anderen Gebäudefundament aus über den Außenbereich (= Erdreich, reale Erde) erfolgt. In diesem Fall hat das Korrosionsproblem eine vergleichsweise große Bedeutung. Aus einem kleinen ohmschen Anteil der Erdungsimpedanz $Z_E$ läßt sich hingegen schließen, daß die Rückführung der Erdverbindung zur speisenden Energiequelle 13 über den Innenbereich desselben Gebäudefundaments (= interne, imaginäre Erde) erfolgt. In diesem Fall ist das Korrosionsproblem reduziert.

Das beim vorstehend beschriebenen Prüfverfahren angewandte Impulsreflexionsverfahren und Impedanzmeßverfahren sind vorteilhaft in einem einzigen Meßsystem integriert. Dieses Meßsystem kann auch eine Signaleinheit enthalten, welche dem Prüfpersonal nach einer entsprechenden Verarbeitung der Meßdaten das Ergebnis der Zustandsüberprüfung z.B. als "Gut/Schlecht"-Information signalisiert.

In Fig.6 ist eine weitere elektrische Vorrichtung 10 in Form einer schematisch dargestellten Blitzschutzanlage 18 dargestellt. In diesem Fall ist der Vorrichtungs-Erder 11 bereits im Betriebszustand von der Erdung 12,14 der zugeordneten Energiequelle 13 getrennt. Dabei ist der Vorrichtung 10 diejenige Energiequelle 13 zugeordnet, welche während des Prüfverfahrens zur Belastung des Vorrichtungs-Erders 11 und der Erdverbindung mit einer Prüfenergie $E_p$ dient. Zur Ermittlung der Erdungsimpedanz $Z_E$ werden bei dem Ausführungsbeispiel gemäß Fig.6 grundsätzlich die gleichen Messungen durchgeführt, die anhand von Fig.1 bis Fig.5 erläutert worden sind. Hierbei sei erwähnt, daß der Widerstand einer ordnungsgemäßen Blitzschutzanlage gegenüber der Erdungsimpedanz $Z_E$ vernachlässigbar klein ist und die Prüfenergie $E_p$ deshalb im Sinne einer einfachen Verfahrensdurchführung in den dem Vorrichtungs-Erder 11 abgewandten Bereich der Blitzschutzanlage 18 eingeleitet werden kann, ohne die Meßergebnisse zur Ermittlung der Erdungsimpedanz $Z_E$ zu verfälschen. Vorzugsweise wird die Prüfenergie $E_p$ derart vorbestimmt, daß sie mindestens der bei einem Blitzschlag über die Erde abgeleiteten elektrischen Energie entspricht.

Vorgeschriebene, jedoch bislang nur bedingt ausführbare Erdungsmessungen in Energieversorgungsanlagen, im Industrienetz und EVU(= Energieversorgungsunternehmen)-Netz lassen sich mit dem Prüfverfahren zuverlässig und exakt realisieren. Das vorstehend beschriebene Prüfverfahren läßt sich allgemein auf ein mehrphasiges und auch ein einphasiges elektrisches Netz anwenden. Mittels des Prüfverfahrens lassen sich z.B. Erdnetze, Blitzschutzerden und Anlagenerden überprüfen.

**Patentansprüche**

1. Verfahren zur Prüfung der Erdverbindung einer an einen Erder (11) angeschlossenen elektrischen Vorrichtung (10, 16, 18),
   **gekennzeichnet durch**
   folgende Verfahrensschritte:

a) in den von einer der Vorrichtung (10,16,18) zugeordneten und geerdeten elektrischen Energiequelle (13) getrennten Erder (11) wird mindestens ein elektrisches Signal (S₁) eingespeist und gemäß dem Impulsreflexions-Prinzip nach der Reflexion als ein erstes Meßergebnis (S₁ᵣ) gemessen,
b) der Erder (11) wird an eine Phase der zugeordneten Energiequelle (13) angeschlossen zur Belastung der Erdverbindung mit einer elektrischen Prüfenergie ($E_p, I_p, t_p$),
c) nach beendeter Belastung und Trennung des Erders (11) von der Energiequelle (13) wird in den Erder (11) erneut das mindestens eine elektrische Signal ($S_2 = S_1$) eingespeist und gemäß dem Impulsreflexions-Prinzip nach der Reflexion als ein zweites Meßergebnis ($S_{2R}$) gemessen,
d) das erste Meßergebnis ($S_{1R}$) und das zweite Meßergebnis ($S_{2R}$) werden miteinander verglichen und
e) mittels des Vergleichsergebnisses wird der Zustand der Erdverbindung bestimmt.

**2.** Verfahren nach Anspruch 1,
**dadurch gekennzeichnet,**
**daß** der mit der Vorrichtung (10,16,18) im Betriebszustand elektrisch verbundene Erder (11) vor dem Verfahrensschritt a) von der Vorrichtung (10,16,18) elektrisch getrennt wird.

**3.** Verfahren nach Anspruch 1,
**dadurch gekennzeichnet,**
**daß** der Erder (11) mit einem Prüfstrom ($I_p$) belastet wird.

**4.** Verfahren nach Anspruch 3,
**dadurch gekennzeichnet,**
**daß** der Erder (10)

- mit einem Prüfstrom ($I_p$) belastet wird, der etwa dem bei einem Kurzschluß auftretenden maximalen Kurzschlußstrom entspricht und /oder
- während einer Prüfzeitdauer ($t_p$) belastet wird, die etwa der Ansprechzeit eines Auslöseorgans (15) entspricht, welches im Störfall die Vorrichtung (10,16,18) von der Energiequelle (13) elektrisch trennt.

**5.** Verfahren nach Anspruch 1,
**dadurch gekennzeichnet,**
**daß** während oder nach der Belastung der Erdverbindung zwischen einer Phase (L1,L2,L3) der Energiequelle (13) und des getrennten Erders (11) eine Impedanz als Gesamtimpedanz ($Z_{ges}$) gemessen wird.

**6.** Verfahren nach Anspruch 5,

**dadurch gekennzeichnet,**

- **daß** die Gesamtimpedanz ($Z_{ges}$) und eine Netzimpedanz ($Z_{Netz}$) miteinander verknüpft werden zur Ermittlung einer Erdungsimpedanz ($Z_E$) der Erdverbindung und
- **daß** die Netzimpedanz ($Z_{Netz}$) als Impedanz zwischen zwei Phasen (L1,L2,L3) der Energiequelle (13) oder zwischen Phase (L1,L2,L3) und Neutral- bzw. Schutzleiter (N/PE) der Energiequelle (13) gemessen wird.

**7.** Verfahren nach Anspruch 6,
**dadurch gekennzeichnet,**
**daß** zur Ermittlung der Erdungsimpedanz ($Z_E$) eine Gleichung der Form

$$Z_E = R_E + X_E \approx Z_{ges} - \tfrac{1}{2} Z_{Netz}$$

gebildet wird, wobei

- $Z_E$ die Erdungsimpedanz ist,
- $Z_{ges}$ die Gesamtimpedanz ist,
- $Z_{Netz}$ die Netzimpedanz ist,
- $R_B$ der Realanteil von $Z_B$, d.h. der Erdungswiderstand ist und
- $X_g$ der Imaginäranteil von $Z_B$ ist.

**8.** Verfahren nach Anspruch 5,
**dadurch gekennzeichnet,**
**daß** die Gesamtimpedanz ($Z_{ges}$) unter Verwendung der Prüfenergie ($E_p, I_p, t_p$) während der Belastung der Erdverbindung (10) gemessen wird.

**Claims**

**1.** A process for testing the earth connection of an electrical device (10, 16, 18) connected to an earth electrode (11),
**characterised by**
the following process steps:

a) at least one electrical signal (S₁) is fed into the earth electrode (11) which is separated from an earthed electrical power source (13) assigned to the device (10, 16, 18) and measured using the pulse reflection method after reflection as a first test result ($S_{1R}$),
b) the earth electrode (11) is connected to a phase of the assigned power source (13) in order to apply electrical test power ($E_p, I_p, t_p$) to the earth connection,
c) once current has been applied and the earth electrode (11) has been separated from the power source (13), the at least one electrical signal ($S_2 = S_1$) is fed into the earth electrode (11) and measured using the pulse reflection method after reflection as a second test result ($S_{2R}$),

d) the first test result ($S_{1R}$) and the second test result ($S_{2R}$) are compared and

e) the state of the earth connection is determined by means of the comparison of the results.

2. A process in accordance with claim 1, **characterised in that** the earth electrode (11) which is electrically connected to the device (10, 16, 18) under operating conditions is electrically separated from the device (10, 16, 18) prior to step a) of the process.

3. A process in accordance with claim 1, **characterised in that** a test current ($I_p$) is applied to the earth electrode (11).

4. A process in accordance with claim 3, **characterised in that**

- a test current ($I_p$) which corresponds approximately to the maximum short circuit current occurring in the event of a short circuit is applied to the earth electrode (11) and/or
- a current is applied to the earth electrode (11) for a test period ($t_p$) which corresponds approximately to the response time of a tripping element (15) which electrically separates the device (10, 16, 18) from the power source (13) in case of a fault.

5. A process in accordance with claim 1, **characterised in that** an impedance is measured as the total impedance ($Z_{ges}$) during or after current is applied to the earth connection between a phase (L1, L2, L3) of the power source (13) and the separated earth electrode (11).

6. A process in accordance with claim 5, **characterised in that**

- the total impedance ($Z_{ges}$) and a grid impedance ($Z_{netz}$) are linked together to determine an earth impedance ($Z_E$) of the earth connection and
- the grid impedance ($Z_{netz}$) is measured as the impedance between two phases (L1, L2, L3) of the power source (13) or between phase (L1, L2, L3) and neutral or protective conductors (N/PE) of the power source (13).

7. A process in accordance with claim 6, **characterised in that**

in order to determine the earth impedance ($Z_E$) the following equation:

$$Z_E = R_E + X_E \approx Zges - \tfrac{1}{2} Z_{netz}$$

is formed, where

- $Z_E$ is the earthing impedance,
- $Z_{ges}$ is the total impedance,
- $Z_{netz}$ is the grid impedance,
- $R_E$ is the real component of $Z_E$, i.e. the earth resistance and
- $X_E$ is the imaginary component of $Z_E$.

8. A process in accordance with claim 5, **characterised in that** the total impedance ($Z_{ges}$) is measured using the test power ($E_p$, $I_p$, $t_p$) while current is being applied to the earth connection.

**Revendications**

1. Procédé pour tester une connexion à la terre d'un dispositif électrique (10, 16, 18) raccordé à une prise de terre (11), **caractérisé par** les étapes de procédé suivantes:

a) dans la prise de terre (11) séparée d'une source d'énergie électrique (13) associée au dispositif (10, 16, 18) et mise à la terre est injecté au moins un signal électrique ($S_1$), lequel est mesuré après La réflexion d'après le principe de réflexion des impulsions pour obtenir un premier résultat de mesure ($S_{1R}$),

b) la prise de terre (11) est raccordée à une phase de la source d'énergie associée (13) pour appliquer à la connexion à la terre une charge électrique constituée par une énergie de contrôle électrique ($E_p$, $I_p$, $t_p$),

c) après l'arrêt de l'application de la charge électrique et après la séparation de la prise de terre (11) par rapport à la source d'énergie (13), l'au moins un signal électrique ($S_2 - S_1$) est à nouveau injecté dans la prise de terre (11) et est mesuré après la réflexion d'après le principe de réflexion des impulsions pour obtenir un deuxième résultat de mesure ($S_{2R}$),

d) le premier résultat de mesure ($S_{1R}$) et le deuxième résultat de mesure ($S_{2R}$) sont comparés entre eux et

e) l'état de la connexion à la terre est déterminé à l'aide du résultat de la comparaison.

2. Procédé selon la revendication 1, **caractérisé en ce que** la prise de terre (11), qui est reliée électriquement avec le dispositif (10, 16, 18) en état de fonctionnement, fait l'objet d'une séparation électrique par rapport au dispositif (10, 16, 18) avant l'étape de procédé a).

3. Procédé selon la revendication 1, **caractérisé en ce qu'**à la prise de terre (11) est appliquée une charge électrique constituée par un courant de contrôle (Ip).

4. Procédé selon la revendication 3, **caractérisé en ce qu'**à la prise de terre (11)

   - est appliquée une charge électrique constituée par un courant de contrôle ($I_p$) qui correspond approximativement au courant de court-circuit maximum apparaissant en cas de court-circuit et/ou
   - est appliquée une charge électrique durant une période de contrôle ($t_p$) qui correspond approximativement au temps de réponse d'un élément de déclenchement (15) qui, en cas d'incident, réalise une séparation électrique du dispositif (10, 16, 18) par rapport à la source d'énergie (13).

5. Procédé selon la revendication 1, **caractérisé en ce que**, lors de l'application de la charge électrique à la connexion à la terre ou après cette application, une impédance est mesurée en tant qu'impédance d'ensemble ($Z_{ges}$) entre une phase (L1 L2, L3) de la source d'énergie (13) et la prise de terre (11) ayant fait l'objet d'une séparation.

6. Procédé selon la revendication 5, **caractérisé**

   - **en ce que** l'impédance d'ensemble ($Z_{ges}$) et une impédance de réseau ($Z_{Netz}$) sont combinées entre elles pour déterminer une impédance de mise à la terre ($Z_E$) de la connexion à la terre et
   - **en ce que** l'impédance de réseau ($Z_{Netz}$) est mesurée en tant qu'impédance entre deux phases (L1, L2, L3) de la source d'énergie (13) ou entre la phase (L1, L2, L3) et le conducteur neutre ou le conducteur de protection (N/PE) de la source d'énergie (13).

7. Procédé selon la revendication 6, **caractérisé en ce que**, pour la détermination de l'impédance de mise à la terre ($Z_E$), est formée une équation constituée comme suit :

   $$Z_E = R_g + X_g = Z_{ges} - \tfrac{1}{2} Z_{Netz},$$

   où

   - $Z_E$ est l'impédance de mise à la terre,

   - $Z_{ges}$ est l'impédance d'ensemble,
   - $Z_{Netz}$ est l'impédance du réseau,
   - $R_g$ est la quote-part réelle de $Z_E$, c'est-à-dire la résistance de mise à la terre et
   - $X_g$ est la quote-part imaginaire de $Z_E$.

8. Procédé selon la revendication 5, **caractérisé en ce que** l'impédance d'ensemble ($Z_{ges}$) est mesurée pendant l'application de la charge électrique à la connexion à la terre (10) et en utilisant l'énergie de contrôle ($E_p$, $I_p$, $t_p$).

Fig. 1

*Fig.2*

*Fig. 3*

Fig. 4

Fig. 5

Fig. 6